Europäisches Patentamt

European Patent Office

Office européen des brevets

(11) Publication number : **0 228 405**
**B1**

# (12) EUROPEAN PATENT SPECIFICATION

(45) Date of publication of patent specification :
26.04.89

(21) Application number : 86903653.3

(22) Date of filing : 16.05.86

(86) International application number :
**PCT/SE 86/00231**

(87) International publication number :
**WO/8607497 (18.12.86 Gazette 86/27)**

(51) Int. Cl.⁴ : **H 01 R   4/64**

(54) **EARTHING SYSTEM FOR AN APPARATUS CABINET.**

(30) Priority : 14.06.85 SE 8502976

(43) Date of publication of application :
15.07.87 Bulletin 87/29

(45) Publication of the grant of the patent :
26.04.89 Bulletin 89/17

(84) Designated contracting states :
**AT BE CH DE FR GB IT LI NL**

(56) References cited :

**None**

(73) Proprietor : **TELEFONAKTIEBOLAGET L M ERICSSON**
**S-126 25 Stockholm (SE)**

(72) Inventor : **OLSSON, Rolf, Torbjörn**
**Norrskensbacken 21**
**S-146 00 Tullinge (SE)**
Inventor : **ANDERSSON, Hans, Olov, Wilhelm**
**Vikingavägen 16**
**S-191 45 Sollentuna (SE)**

(74) Representative : **Hedberg, Sten Torsten et al**
**Telefonaktiebolaget L M Ericsson**
**S-126 25 Stockholm (SE)**

## Description

Technical field

The invention relates to an earthing system for apparatus cabinets containing electrical equipment in accordance with the preamble to the following independent claim.

Background art

Where electronic equipment is placed in apparatus cabinets, there is the requirement that occurring earth currents, which can be considerable, shall be led off with a rise in potenial which is so small that the sensitive electronic equipment is not damaged by it. One kind of earth connection used so far, comprises conductors with cable shoes placed between the apparatus and their stand, the shoes being screwed to the apparatus and to the stand. Another kind of earth connection is a serrated washer placed between the apparatus casing and the plates of the stand. A fastening screw which fastens the apparatus to the stand is taken through this serrated washer. An example of such a contact means is described in SE - C- 7509869.9 (387201).

Disclosure of invention

The invention described here includes, inter alia, a further development of the mentioned serrated washer. The invention is characterized as disclosed in the characterizing portions of the following claims.

In the earthing system there are bars which are connected to each other, and together thus have conductive capacity which is so great that occuring earth currents are led away with only a small rise in potential as a result, and spring-biased contact plates at the junction points between the bars give a continous, low transfer resistance between them, although the material of the bars is of soft metal, in this case aluminium, which yields somewhat to compression stress.

The horizontal bars in side-by-side apparatus cabinets are united by connection bars of aluminium with the aid of the same spring-biased contact plate as unites the bars in an apparatus cabinet.

Brief description of drawings

An example of an earthing system in accordance with the invention is described in the following with reference to the accompaning drawings, where

Figure 1 illustrates two apparatus cabinets with bars

Figure 2 illustrates a junction point between a vertical and horizontal bar

Figure 3 and 4 illustrate a spring-biased contact plate

Figure 5 illustrates a contact plate inserted in an intersection point between bars

Figure 6 illustrates a connection bar between horizontal bars.

Embodiment of invention

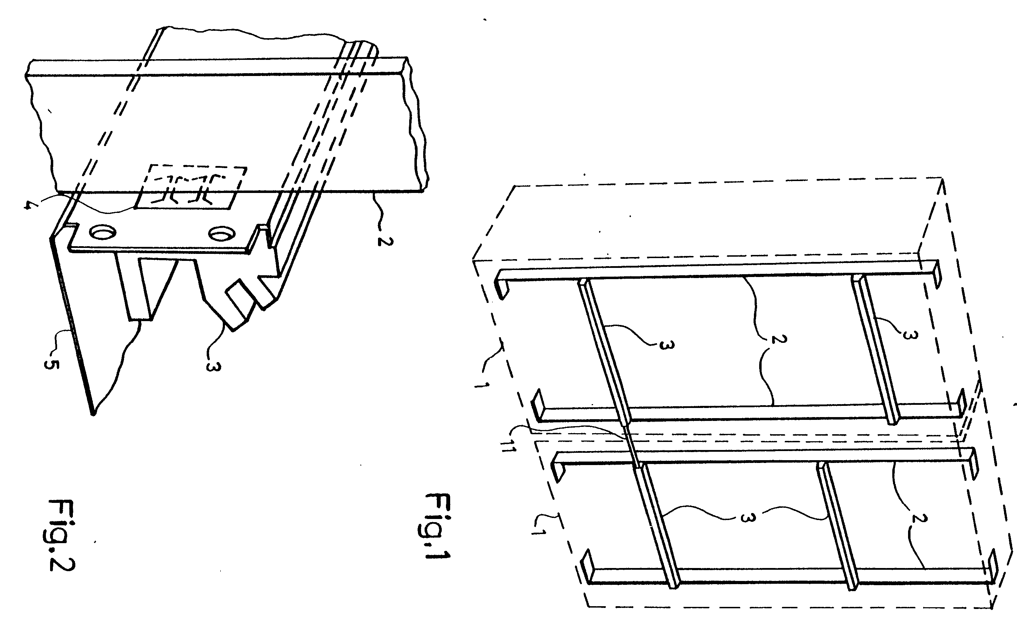

Two apparatus cabinets 1 are illustrated as an example in Figure 1, each containing two vertical bars 2 and two horizontal bars 3. Each vertical bar 2 is bent inwards at right angles at each end, and in each cabinet there is an unillustrated connection terminal arranged on one of the bent-in parts for connecting an earth conductor. Any of the four bent-in parts may be used for connecting the earth conductor.

A contact plate 4 is disposed, as illustrated in Figure 2, at an intersection point between one of the vertical bars 2, and one of the horizontal bars 3. The vertical bar 2 has a rectangular cross section and is attached to the side wall of the apparatus cabinet with unillustrated fastening screws, while the horizontal bar 3, which is carried by a surrounding plate 5, is fastened to the apparatus cabinet with other fastening screws and pressed against the narrow edge of the vertical bar.

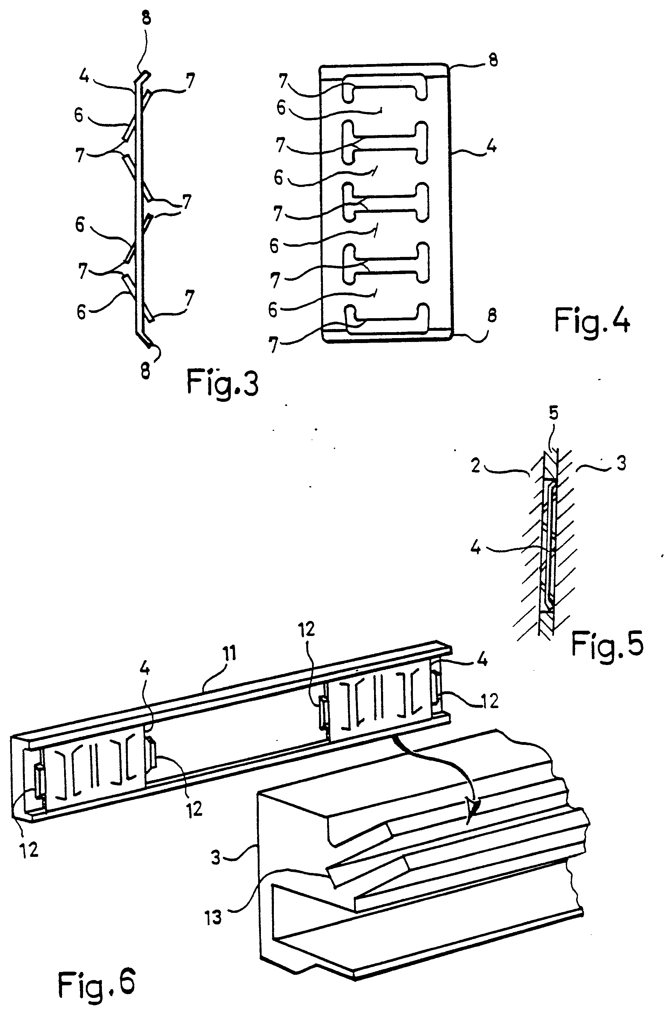

As illustrated in Figures 3 and 4, the contact plate 4 has a rectangular shape, punched out from sheet metal, and is provided with a plurality of contact tongues, four in the example, which are punched out in a row along the centre line of the plate and alternatingly bent out of the plane of the plate so that there is formed a total of eight contact-making edges 7. The edges 7 are right-angular and sharp to give good electrical contact against the bars.

A small part of the short ends 8 of the contact plate is somewhat bent out from one face of the plate to form retaining flanges.

The material in the contact plate 4 is tin bronze and is tinned, whereby the plate will give durable electrical contact against the aluminium bars without the danger of corrosion needing to be considered. Alternatingly, the contact plate may be made from some other similar material, e. g. beryllium copper.

As previously mentioned, and as will be more clearly perceived from Figure 5, the contact plate 4 is inserted in an opening in the plate 5 and is there pressed between the vertical bar 2 and the horizontal bar 3. The retaining flanges 8 of the contact plate are urged against the edges in the opening of the plate 5 so that the contact plate will be prevented from falling out during assembly, and the contact tongues 6 are bent such that the thickness of the contact plate measured over the edges 7 is greater than the space between both bars, such that the contact edges will engage against the bars with a continuous pressure after insertion. Since the contact plate 4 is disposed in the plate 5 the contact tongues 6 are prevented from being completely pressed together.

In the inventive earthing system, there is further included, as will be seen from Figures 1 and 6, a connection bar 11 for connecting the horizontal bars 3 in side-by-side apparatus cabinets. As with the other bars, the material in the connection bar 11 is aluminium and its cross section is substantially rectangular with two low outstanding edges on one of the wide sides of the bar, so that its cross section has the form of a shallow U. At either end of the connection bar, two nodules 12 are pressed into the bar along its centre line in the same direction as that of the edges of the bar. The nodules and the edges of the bar are adapted to give retention of the previously described contact plate 4, there being one contact plate at either end of the bar 11.

The horizontal bar 3 is provided with a longitudinal groove 13 with a width and depth suited to the reception of the connection bar 11 with its accompanying plate 4 in the manner illustrated by a curved arrow in Figure 6. The thickness of the horizontal bar 3 is adjusted in relation to the width of the groove 13 so that the contact tongues on the contact plate 4 are prevented from being completely pressed together.

To enable mounting the connection bar 11, the apparatus cabinet 1 is provided with a plurality of unillustrated openings at different heights in the side walls of the cabinets.

The horizontal bars 3 and indirectly the vertical bars 2 also, in two or more cabinets are electrically connected to each other with one or more connection bar 11, whereby occurring earth currents are effectively spread in the bars and are led away to the earth conductors connected to each cabinet, so that occuring potential rises are limited to a value which is not dangerous.

Electronic apparatus placed in the apparatus cabinet 1 are each provided with an earth conductor intended for connection to one of the horizontal bars 3, preferably with a connection means of the kind described in SE-C-7509890-5 (387480) and which is intended for fastening by a screw, screwed into the groove 13 of the horizontal bar.

## Claims

1. Earthing system for apparatus cabinets containing electrical equipment, in which there are included bars of a yielding, soft metal, e. g. aluminium, for leading off earth currents, characterized by a first kind of bars (2), and a second kind of bars (3) and by contact-making, spring-biased contact plates (4) at the connection points between the bars, the contact plates being inserted in an opening in a plate (5) between the bars (2, 3) to prevent complete pressing together of the contact plate.

2. Earthing system as claimed in claim 1, characterized by an aluminium bar (11) connecting the horizontal bars (3) in side-by-side apparatus cabinets 1 and by the said contact-making, spring-biased contact plates (4) in the connection points between the bars.

3. Earthing system as claimed in claim 1 or 2, characterized by the contact plate (4) being rectangular and by contact tongues (6) arranged in rows projecting from both side faces of the contact plate.

4. Earthing system as claimed in claim 3, characterized by a small part of the short ends (8) of the contact plate (4) being bent out from one face of the plate to form retaining flanges.

5. Earthing system as claimed in claim 3, characterized in that the material in the contact plate (4) is tinned tin bronze.

## Patentansprüche

1. Erdungssystem für Geräteschränke mit elektrischen Einrichtungen, das zur Ableitung von Erdungsströmen Stäbe aus einem nachgiebigen, weichen Metall, wie beispielsweise Aluminium aufweist, gekennzeichnet durch eine erste Art von Stäben (2) und eine zweite Art von Stäben (3) und durch Kontakt herstellende, federbelastete Kontaktplatten (4) an den Verbindungspunkten zwischen den Stäben, wobei die Kontaktplatten in eine Öffnung in einer Platte (5) zwischen den Stäben (2, 3) eingesetzt sind, um ein vollständiges zusammendrücken der Kontaktplatte zu verhindern.

2. Erdungssystem nach Anspruch 1, gekennzeichnet durch einen Aluminiumstab (11), der die horizontalen Stäbe (3) in den Seite an Seite liegenden Geräteschränken (1) verbindet, und durch die Kontakt herstellenden, federbelasteten Kontaktplatten (4) in den Verbindungspunkten zwischen den Stäben.

3. Erdungssystem nach Anspruch 1 oder 2, dadurch gekennzeichnet, daß die Kontaktplatte (4) rechteckförmig ist und daß Kontaktzungen (6) in Reihen angeordnet sind, die aus den beiden Seiten der Kontaktplatte abstehen.

4. Erdungssystem nach Anspruch 3, dadurch gekennzeichnet, daß ein kleiner Teil 1 der kurzen Enden (8) der Kontaktplatte (4) aus einer Seite der Kontaktplatte daraus umgebogen ist, um Halteflansche zu bilden.

5. Erdungssystem nach Anspruch 3, dadurch gekennzeichnet, daß der Werkstoff der Kontaktplatte (4) verzinnte Zinnbronze ist.

## Revendications

1. Système de mise à la terre pour armoires d'appareillage contenant du matériel électrique, qui renferment des barres en un métal souple et doux, par exemple de l'aluminium, pour évacuer des courants de terre, caractérisé par un premier type de barres (2) et un second type de barre (3) et par des plaques (4) de contact rappelées par ressort, établissant des contacts aux points de connexion entre les barres, les plaques de contact étant insérées dans une ouverture d'une plaque (5) située entre les barres (2, 3) afin d'empêcher que la plaque de contact soit complètement comprimée.

2. Système de mise à la terre selon la revendication 1, caractérisé par une barre d'aluminium (11) connectant les barres horizontales (3) situées dans des armoires d'appareillage (1) disposées côte à côte et par lesdites plaques de contact (4) rappelées par ressort, établissant des contacts, dans les points de connexion entre les barres.

3. Système de mise à la terre selon la revendication 1 ou 2, caractérisé par le fait que la plaque (4) de contact est rectangulaire et par des languettes (6) de contact agencées en rangées faisant saillie des deux faces latérales de la plaque de contact.

4. Système de mise à la terre selon la revendication 3, caractérisé par le fait qu'une petite partie des extrémités courtes (8) de la plaque (4) de contact est coudée vers l'extérieur à partir d'une face de la plaque pour former des brides de retenue.

5. Système de mise à la terre selon la revendication 3, caractérisé en ce que la matière de la plaque (4) de contact est du bronze à l'étain, étamé.

Fig.1

Fig.2

Fig.3

Fig.4

Fig.5

Fig.6